# EUROPEAN PATENT APPLICATION

(11) **EP 2 506 333 A2**
(43) Date of publication of application: **03.10.2012**
(21) Application number: 12161514.0
(22) Date of filing: 27.03.2012
(51) Int. Cl.: H01L 51/52, H01L 51/00

(54) **Method for patterning a lacquer layer to hold electrical gridlines**

(30) Priority: 31.03.2011 IN DE09112011
(71) Applicant: Moser Baer India Ltd., 110020 New Delhi (IN)
(72) Inventor: Ter Meulen, Jan Matthijs, 110020 New Dehli (IN); Peters, Patrick, 110020 New Dehli (IN)
(74) Representative: Beck & Rössig European Patent Attorneys

(57) **Abstract**

A method is provided for simultaneously forming functional light structures and grooves configured to hold electrical circuitry on a lacquer layer deposited on a base substrate, which is for use in an optoelectronic device. The method includes applying the lacquer layer on the base substrate and heating it beyond its glass transition temperature to soften it. Thereafter, a stamper is used to simultaneously replicate the grooves and the functional light structures onto the lacquer layer. The stamper has a mating surface, which has negative impressions of the grooves on its first portion and the functional light structures on its second portion. Thereafter, the lacquer layer is cooled and the electrical circuitry is formed in the grooves on the lacquer layer.

## Description

### FIELD OF INVENTION

The invention disclosed herein relates, in general, to semiconductor devices. More specifically, the present invention relates to a method of applying electrical gridlines in the semiconductor devices.

### BACKGROUND

Electrode layers in semiconductor devices like thin film photovoltaic devices (TF-PVs) or organic light emitting devices (OLEDs) are commonly made of transparent conductive oxides (TCO), such as indium tin oxide (ITO), antimony doped tin oxide and cadmium tin oxide.

TCO layers work substantially well for small area semiconductor devices, however, in cases of large area semiconductor devices, conductivity provided by the TCO layer is not sufficient. Due to insufficient conductivity, often there is a voltage drop in the semiconductor device. For example, in case of the OLEDs the voltage drop can be seen as inhomogeneous light intensity in the OLEDs.

This problem can be possibly countered by using a thicker electrode layer. The thicker electrode layer provides a decreased resistance and thereby reduces the voltage drop. However, the transmittance decreases significantly when using the thicker electrode layer.

Therefore, another solution that is also used to increase the conductivity provided by the electrode layer, includes application of electrically conducting gridlines in the semiconductor device to supplement the conductivity of the electrode layer.

The electrically conducting gridlines can be formed on a surface in the semiconductor device by several methods, for example by photolithography. However, photolithography is an expensive process. Besides the costs of setting up the apparatus for photolithography, disposal of waste material produced in the photolithography process is also expensive.

Additionally, the photolithography process allows only a limited number of substrate elements to be processed in a single production cycle, resulting in a low process throughput.

Further, the processes used in the prior art result in formation of the gridlines protruding from the surface. This protrusion leads to problems in functioning of the semiconductor device.

Also, the electrically conducting gridlines are deposited on internal light extraction or light trapping layers of optoelectronic devices, which have light management textures imprinted on them. Therefore, there are chances of damage to the light management textures deposition of the electrically conducting grid lines.

In light of the above discussion, there is a need for an improvement in the method of transferring / application of electrically conducting gridlines to the semiconductor device, that overcome one or more drawbacks present in the prior art.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIGs. 1a and 1b illustrate a stack of layers in an exemplary OLED and an exemplary OPV device, respectively, in accordance with an embodiment of the present invention;
FIGs. 2a and 2b illustrate a cross-sectional view and a top view, respectively, of an exemplary stage during manufacturing of an exemplary optoelectronic device after simultaneous replication of one or more grooves and functional light structures in accordance with an embodiment of the present invention;
FIGs. 2c and 2d illustrates a cross-sectional view and a top view, respectively, of an exemplary stage during manufacturing of an exemplary optoelectronic device after forming an electrical circuitry in the one or more grooves in accordance with an embodiment of the present invention;
FIGs. 3a, 3b, 3c, and 3d illustrate a schematic view of different stages of formation of an exemplary stamper, in accordance with an embodiment of the present invention; and
FIG. 4 is a flow chart describing an exemplary process of manufacturing an optoelectronic device, in accordance with an embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### SUMMARY

The invention provides a method of simultaneously forming functional light structures and grooves for holding electrical circuitry on a lacquer layer deposited on a base substrate, which is for use in an optoelectronic device, for example, an OLED. A stamper, which has negative impressions of the functional light structures as well as the grooves, is used for stamping the lacquer layer of the OLED. During stamping both the grooves and the functional light textures get imprinted on the lacquer layer. The functional light structures are provided to enable light trapping or light extraction. Then the electrical circuitry, i.e., the busbars, is formed in the grooves, for example, by printing or filling the grooves with an electrically conducting material by using any other suitable process.

Since the bus bars are deposited in grooves made on the lacquer layer and not on the surface of the lacquer layer, the bus bars do not protrude from the surface of the lacquer layer. In other words, the bus bars are deposited in the grooves made on the lacquer layer. This prevents any in-homogeneity in the thickness of the electrode layers deposited after the bus bars and also prevents any subsequent electronic problems.

In some embodiments, the invention provides a method of simultaneously forming functional light structures and one or more grooves configured to hold an electrical circuitry on a lacquer layer deposited on a base substrate, which is for use in an optoelectronic device. The method includes applying the lacquer layer on the base substrate, followed by simultaneously replicating the one or more grooves and the functional light structures onto the lacquer layer by using a stamper, which is defined by a mating surface having negative impressions of the one or more grooves on a first portion and the functional light structures on a second portion. The functional light structures enable light trapping or light extraction. Thereafter, the electrical circuitry is formed in the one or more grooves.

In some embodiments, the electrical circuitry is formed by filling the one or more grooves with an electrically conducting material.

In some embodiments, the lacquer layer is cured by exposing the lacquer layer to heat, light and/or ultra-violet radiations, pressure, electric current and/or by chemical curing by selecting a material of the lacquer layer as a mixture of reactive components that facilitate curing, for example, by an exothermic reaction between themselves.

In some embodiments, the simultaneous replication is obtained by first heating the lacquer layer to a temperature greater than its glass transition temperature to soften it, then pressurizing the stamper against the lacquer layer followed by cooling the lacquer layer.

In some embodiments, the one or more grooves have a rectangular cross-section.

The electrical circuitry effectively reduces a voltage drop in the optoelectronic device. Further, in some embodiments, the electrical circuitry does not even protrude from the lacquer layer.

In some embodiments, the lacquer layer includes scattering particles, which further facilitate the light management.

In some embodiments of the invention, a method of simultaneously forming functional light structures and one or more grooves on a base substrate for use in an optoelectronic device is provided. The one or more grooves are configured to hold an electrical circuitry. The method includes applying a lacquer layer on the base substrate, and heating the lacquer layer to a temperature greater than a glass transition temperature of the lacquer layer to soften the lacquer layer. The method also includes providing a stamper defined by a mating surface, which has having negative impressions of the one or more grooves on a first portion and the functional light structures on a second portion. The functional light structures enable light trapping and/or light extraction in the optoelectronic device. The stamper is pressurized against the lacquer layer to enable formation of the one or more grooves and the functional light structures onto the lacquer layer. Thereafter, the lacquer layer is cooled and the electrical circuitry is formed in the one or more grooves.

In some embodiments of the present invention, a stamper for simultaneously forming functional light structures and one or more grooves on a base substrate of an optoelectronic device is provided. The one or more grooves are configured to hold an electrical circuitry in the optoelectronic device. The stamper includes a mating surface configured to be contacted against the lacquer layer. The mating surface includes a first portion and a second portion. The first portion has negative impressions of the one or more grooves, and the second portion has negative impressions of the functional light structures, which enable light trapping and/or light extraction in the optoelectronic device. The stamper enables simultaneous forming of some or all of the one or more grooves and some or all of the functional light structures on the lacquer layer when the mating surface is pressurized against the lacquer layer.

Some exemplary embodiments of the optoelectronic device is an Organic Photovoltaic Device (OPV), an Organic Light Emitting Device (OLED) and a Thin-Film Photovoltaic Device (TF-PV).

### DESCRIPTION OF THE EXEMPLARY EMBODIMENTS

Before describing the present invention in detail, it should be observed that the present invention utilizes a combination of method steps and apparatus components related to a method of manufacturing a semiconductor device. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

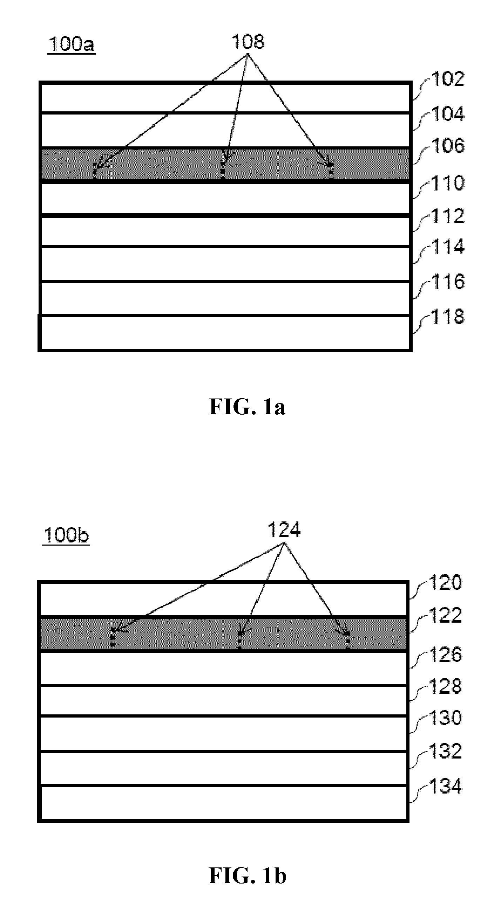

Referring now to the drawings, there is shown in FIG. 1a, a stack of layers in an exemplary OLED 100a, in accordance with an embodiment of the present invention. The OLED 100a is shown to include an external light extraction layer 102, a base substrate 104, an internal light extraction layer 106, electrical circuitry 108, a first electrical contact 110, one or more organic layers 112 and 114, a second electrical contact 116 and a cover substrate 118, which encapsulates the internal light extraction layer 106, the electrical circuitry 108, the first electrical contact 110, the one or more organic layers 112 and 114, and the second electrical contact 116 between itself and the base substrate 104.

For the purpose of the description, the OLED 100a has been shown to include only those layers that are pertinent to the description of the invention. However, it should be understood that the invention is not limited to the layers listed above. In some cases, the OLED 100a may include additional layers to enhance efficiency or to improve reliability, without deviating from the scope of the invention.

Some real life examples of the OLED 100a can include, but are not limited to, Organic Light Emitting Diode (OLED), White Organic Light Emitting Diode (W-OLED), Active-matrix Organic Light Emitting Diodes (AMOLED), Passive-matrix Organic Light Emitting Diodes (PMOLED), Flexible Organic Light Emitting Diodes (FOLED), Stacked Organic Light Emitting Diodes (SOLED), Tandem Organic Light Emitting Diode, Transparent Organic Light Emitting Diodes (TOLED), Top Emitting Organic Light Emitting Diode (TOLED), Bottom Emitting Organic Light Emitting Diode, Fluorescence doped Organic Light Emitting Diode (FOLED) and Phosphorescent Organic Light Emitting Diode (PHOLED).

The base substrate 104 provides strength to the OLED 100a, and also acts as an emissive surface of the OLED 100a when in use. The examples of the base substrate 104 include, but are not limited to, glass, flexible glass, polyethylene terephthalate (PET), polyethylene naphthalate (PEN), and other transparent or translucent material.

The first electrical contact 110 and the second electrical contact 116 are used to apply a voltage across the one or more organic layers 112 and 114. The first electrical contact 110 and can be implemented with, for example, a transparent conductive oxide (TCO), a conductive polymer layer, like, Poly (3,4-ethylenedioxythiophene) poly(styrenesulfonate) (PEDOT-PSS) or a thin metallic layer. For the purpose of this description, the first electrical contact 110 is explained to be embodied as a TCO layer. TCOs are doped metal oxides, examples of TCOs include, but are not limited to, Aluminum-doped Zinc Oxide (AZO), Indium Zinc Oxide (IZO), Boron doped Zinc Oxide (BZO), Gallium doped Zinc Oxide (GZO), Fluorine doped Tin Oxide (FTO) and Indium doped Tin Oxide (ITO). Further, the second electrical contact 116 can be implemented with metals with appropriate work function to make injection of charge carriers, for example, calcium, aluminum, gold, and silver.

The one or more organic layers 112 and 114 can be implemented with any organic electroluminescent material such as a light-emitting polymer, evaporated small molecule materials, light-emitting dendrimers or molecularly doped polymers.

In an OLED light emitted by the one or more organic layers 112 and 114 needs to pass through the base substrate 104. However, when light is incident from a high refractive index material onto an interface with a lower refractive index material or medium, the light undergoes total internal reflection (TIR) for all incidence angles greater than the critical angle θ_{c}, defined by θ_{c} = sin⁻¹ (n₂/n₁), where n₁ and n₂ are the refractive indices of the high refractive index material and low refractive index material, respectively. Due to the same reason, when the light emitted by the one or more organic layers 112 and 114 reaches an interface with the base substrate 104, a substantial amount of light is reflected back into the one or more organic layers 112 and 114.

This can be prevented by presence of an internal light extraction layer 106 or a lacquer layer 106 having functional light structures, as the functional light structures are capable of changing the propagation direction of the light emitted by the one or more organic layers 112 or 114 at the interface with the base substrate 104. This helps to reduce the reflection (or TIR) of the light back into the OLED 100a. The functional light structures on the internal light extraction layer 106 may include geometries having dimensions in the order of the wavelength of the light to facilitate the change in propagation direction of the emitted light by diffraction. The functional light structures on the internal light extraction layer 106 may also include geometries having larger dimensions than the wavelength of the light to facilitate the change in propagation direction of the emitted light by refraction. Therefore, presence of an internal light extraction layer 106 having functional light structures to act as the absorbing and the scattering entities which eliminates or reduces the TIR, increases the efficiency of the OLED 100a. In a similar manner, the external light extraction layer 102 reduces or eliminates the TIR at an interface between the base substrate 104 and an ambient medium.

The functional light structures can bring about a change in the light propagation direction by either diffraction or refraction. Usually, the functional light structures having dimensions in the order of a wavelength of the light, usually change the light propagation direction by diffraction. Examples of the functional light structures that change the light propagation direction by diffraction include, but are not limited to, a ID grating and a 2D grating. The functional light structures having dimensions larger than a wavelength of the light, usually change the light propagation direction by refraction. Examples of the functional light structures that change the light propagation direction by refraction include, but are not limited to, a lens, a cone, and a pyramid.

Additionally, in cases of large area OLEDs, conductivity provided by a TCO layer of the first electrical contact 110 is not sufficient, leading to a voltage drop in the large area OLEDs. This voltage drop can be seen as inhomogeneous light intensity in the large area OLEDs. This can be prevented by providing the electrical circuitry 108 in addition to the first electrical contact 110. The electrical circuitry 108 can supplement the conductivity provided by the first electrical contact 110. The electrical circuitry 108 can be in the form of a grid of highly conductive metal lines or busbars or electrical gridlines or circuits that are capable of providing an electric current path across entire surface of the base substrate 104 and the first electrical contact 110. For example in an OLED, this ensures that a uniform voltage is provided across the entire surface and that there is no voltage drop causing inhomogeneous light emission. In the figure the electrical circuitry 108 is shown to be embedded in the internal light extraction layer 106 such that the electrical circuitry 108 does not protrude out of a surface of the internal light extraction layer 106, thereby providing a flat surface for the first electrical contact 110 to be deposited. This in turn prevents any in-homogeneity in thickness of the first electrical contact 110 and also prevents any electronic problems or device degradation.

Referring now to FIG. 1b, there is shown a stack of layers in an exemplary OPV device 100b, in accordance with an embodiment of the present invention. The OPV device 100b is shown to include a transparent substrate 120, a light trapping layer 122 or a lacquer layer 122, electrical circuitry 124, a first electrical contact 126, one or more organic layers 128 and 130, a second electrical contact 132 and a cover substrate 134.

In the OPV device 100b, the light falling on the one or more organic layers 128 and 130 enable generation of electricity through the organic layers 128 and 130, which is extracted into external circuits by the first and second electrical contacts 126 and 132. In the OPV device 100b, the light trapping layer 122 including functional light structures is provided to increase an optical path of the light transmitted in to the OPV device 100b. Similarly, as described for OLED 100a, in cases of large area OPV devices, conductivity provided by a TCO layer of the first electrical contact 126 is not sufficient, leading to a voltage drop in the large area OPV devices. This voltage drop can be prevented by providing the electrical circuitry 124 in addition to the first electrical contact 126. The electrical circuitry 124 is similar in characteristics to the electrical circuitry 108 defined in conjunction with FIG. 1a.

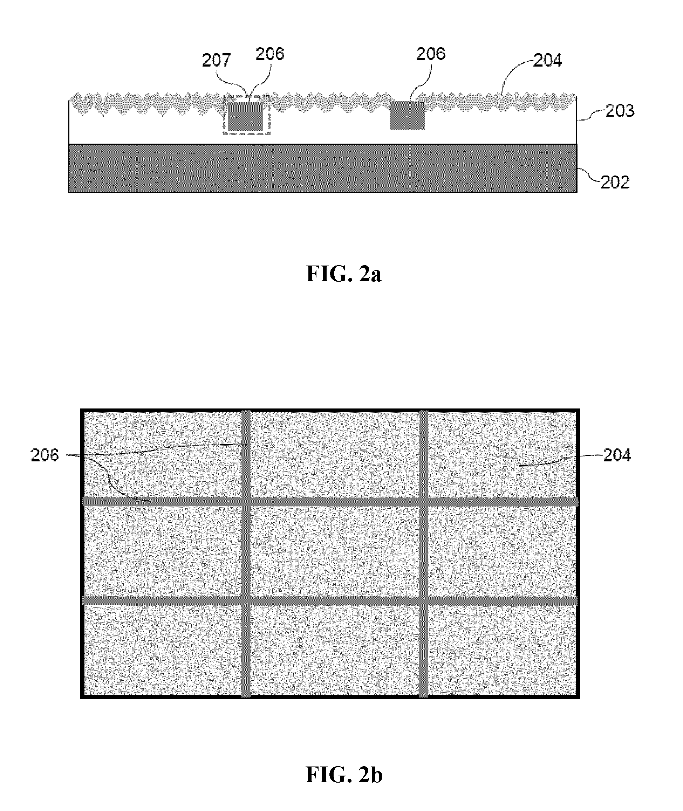

Moving on to FIG. 2a, there is illustrated a cross-sectional view of an exemplary stage during manufacturing of an exemplary optoelectronic device, for example, the OLED 100a and OPV 100b shown in FIGs 1a and 1b. The stage shown is after the one or more grooves 206 and functional light structures 204 have been replicated on a lacquer layer 203 disposed on the base substrate 202. The functional light structures 204 as described in conjunction with FIGs. 1a and 1b enable light extraction and light trapping in cases of an OLED and an OPV device respectively. The functional light structures 204 are usually sub-micron sized micro-textures that are preferably one of periodic and quasi-periodic in nature. The one or more grooves 206 are configured to hold an electrical circuitry in them to facilitate better current distribution and lesser voltage drop in the optoelectronic device, i.e., the OLED 100a or the OPV 100b.

The functional light structures are usually formed on the optoelectronic device by a replication process. According to the replication process a stamper having a micro-textured surface corresponding to a negative impression of the functional light structures 204 is contacted with the lacquer layer 203 deposited onto the base substrate 202, thereby imprinting the functional light structures 204 onto the lacquer layer 203. In an embodiment, the lacquer layer 203 can include scattering particles that further enhance light management properties of the optoelectronic device.

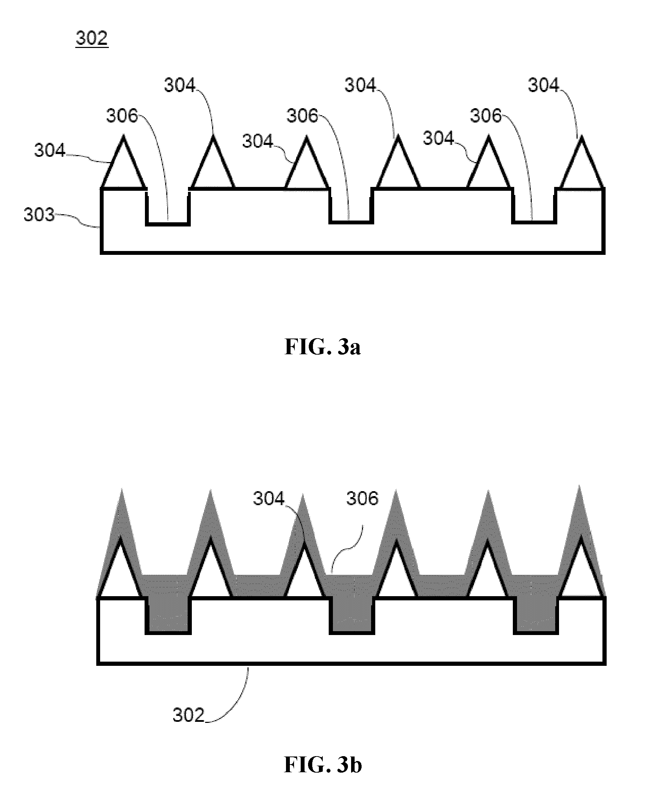

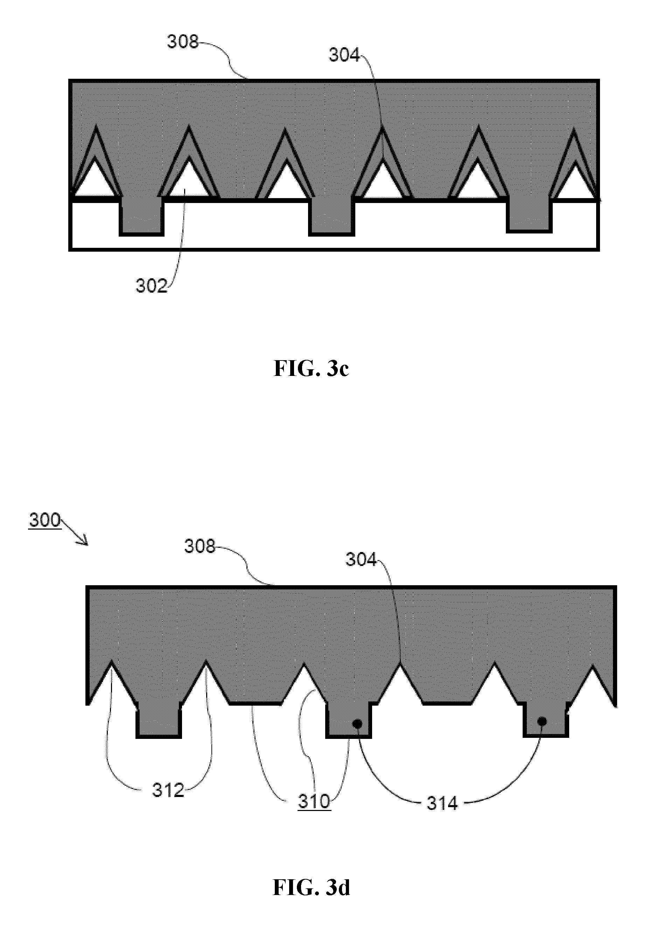

According to the present invention, the stamper used for forming the functional light structures 204, also includes negative impressions of the one or more grooves 206 in addition to the negative impression of the functional light structures 204. The stamper will be explained in greater detail in conjunction with FIG. 3.

In an embodiment, to form the lacquer layer 203, a layer of a curable material, such as a photo-polymer lacquer or a sol-gel material is applied onto the base substrate 202.

Thereafter, the stamper having the negative impressions of the functional light structures 204 and the one or more grooves 206 is pressed into the layer of the curable material. This results in simultaneous replication or imprinting of the functional light structures 204 and the one or more grooves 206 on the layer of the curable material.

Moving on to FIG. 2b, the top view of the exemplary optoelectronic device at the stage shown in FIG. 2a, shows the one or more grooves 206 in the form of a grid of grooves that extend across the surface and occupy a first portion of the substrate. Further, the functional light structures 204 can also be seen to occupy a second portion represented by the portion with a light grey-scale shading in the FIG. 2b.

The functional light structures 204 and the one or more grooves 206 shown in the figure are mere illustrations and have been provided for the purpose of easy description of the invention. It should be understood that the figures have not been drawn to scale and have been drawn to provide an easy understanding of the concept behind the invention.

Further, although a cross-section 207 of the one or more grooves 206 is shown to be rectangular in FIG. 2a, it will be readily apparent to those with ordinary skill in the art that the present invention can be implemented by having the one or more grooves 206 of any other cross-section, for example, but not limited to, a semi-circular cross-section, a square cross-section, and an oval cross-section.

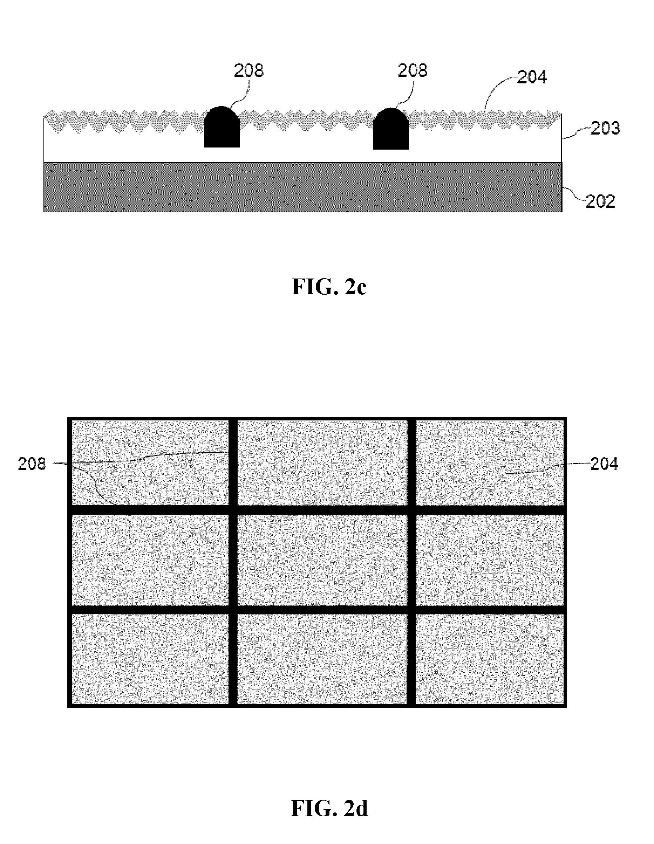

Moving on, in FIG. 2c and 2d there is shown the cross-sectional view and top view, respectively, of an exemplary stage of manufacturing of the optoelectronic device, for example, the OLED 100a, where the electrical circuitry is formed on the one or more grooves 206. The electrical circuitry 208 is shown to be formed in the one or more grooves 206. In an embodiment, the electrical circuitry 208 is formed by printing an electrically conducting material on the one or more grooves 206. In another embodiment, the electrical circuitry 208 is formed by dispensing the electrically conducting material on the one or more grooves 206. Some examples of the electrically conducting material used for the making the electrical circuitry 208 include, but are not limited to, Silver, Aluminium, Chromium, Tin, Cadmium and Nickel. In an exemplary embodiment, the electrical circuitry 208 is formed by applying the electrically conducting material as a paste on the one or more grooves 206. In another exemplary embodiment, the electrical circuitry 208 is applied by screen printing the electrically conducting material on the one or more grooves 206 followed by thermal curing. Other exemplary processes for forming the electrical circuitry 208 include, but are not limited to, evaporation, melt dispensing and powder sintering of the electrically conducting material to get deposited in the one or more grooves 206.

In an embodiment, the electrical circuitry 208 is so formed that it does not protrude out of a surface of the functional light structures 204, thereby a surface available for subsequent deposition of the first electrical contact, for example, the TCO layer is free of step heights due to any protruding portions of electrical circuitry. This also helps in preventing any in-homogeneity in thickness of the first electrical contact and thereby prevents any electronic problems in future. For example, since a top-most surface of the electrical circuitry 208 (refer the highest height of the electrical circuitry 208 in FIG. 2c) is substantially at the same level as the top surface of the functional light structures 204 (refer the highest height of the functional light structures 204 in FIG. 2c), the gaps between the first electrical contact and the surface of the functional light structures 204 are substantially nil, therefore, the corresponding electrical problems are also minimized.

Further, referring to FIG. 2d, the top view of the exemplary optoelectronic device at the stage shown in FIG. 2c, shows the electrical circuitry 208 in the form of grid lines extending across the surface.

As can be seen from above, in order to produce the functional light structures 204 and the one or more grooves 206 on the lacquer layer 203 a stamper needs to be formed. FIGs. 3a, 3b, 3c and 3d illustrate a schematic view of different stages of formation of an exemplary stamper 300 by using an exemplary method in accordance with an embodiment of the present invention. Those with ordinary skill in the art will appreciate that the stamper 300 can be produced by other processes without deviating from the scope of the invention.

The stamper 300 is shown to include a base 308, a mating surface 310, negative impressions 312 corresponding to the functional light structures 204 and negative impressions 314 corresponding to the one or more grooves 206. The functional light structures, the one or more grooves, and their negative impressions shown in the FIGs. 3a, 3b, 3c and 3d are exemplary illustrations provided for easy understanding of the formation of the exemplary stamper 300, and are not drawn to scale or in accordance with the shape and size of the functional light structures, the one or more grooves, and their negative impressions shown in preceding Figures.

Referring to FIG. 3a there is shown a father substrate 302 carrying impressions 304 of the functional light structures 204 and impressions 306 of the one or more grooves 206. The father substrate 302 usually includes a base 303 having a photo-resist layer applied on top of the base 303. Examples of the base 303 of the father substrate 302 include, but are not limited to, a glass plate, a semiconductor wafer and a flat metal plate. Examples of the photo-resist layer can be any phase-transition material like novolac. The impressions 304 and impressions 306 are substantially similar to the functional light structures 204 and the one or more grooves 206 finally desired to be formed on the lacquer layer 203.

In an embodiment, a photo-lithographic process or a thermo-lithographic process is carried out on the photo-resist layer to form the impressions 304 of the functional light structures 204 and impressions 306 of the one or more grooves 206. However, it should be appreciated that the impressions 304 of the functional light structures 204 and impressions 306 of the one or more grooves 206, can also be formed using processes like laser beam recording, E-beam lithography, projection lithography, nano-imprint lithography, mechanical machining and holography. Though the method has been described in relation to photo-lithographic process, it is not intended to be limiting but rather to provide an understandable description of the invention. Thos skilled in the art will appreciate that the impressions 304 and impressions 306 can be formed on the father substrate 302 by using several other processes, including, but not limited to the ones mentioned this paragraph.

During the process the photo-resist layer is locally illuminated by using a focused sub-micron-sized laser spot. The laser spot can be scanned over the photo-resist layer, either by moving the substrate under a stationary spot, or by moving the spot over a stationary substrate, or by a combination of both. In real life applications, a rotating substrate in combination with a linearly moving laser spot in the radial direction is used. In another embodiment, an x,y-stage may be used to move either the substrate or the laser spot in the lateral direction.

The details of the impressions 304 of the functional light structures 204 and impressions 306 of the one or more grooves 206 can be modulated. Also, the process allows formation of a variety of feature and shapes as the impressions 304 of the functional light structures 204. For example, continuous intensity of the laser spot combined with a constant linear movement of the substrate will result in line-shaped features, whereas a pulse-modulated laser spot will result in dot- or dash-shaped features.

Further, height of the impressions 304 of the functional light structures 204 and the impressions 306 of the one or more grooves 206 can also be controlled. Lateral size features of the impressions 304 of the functional light structures can also be modulated.

After development of the father substrate 302, a stamper 300 including the negative replica of the father substrate 302 is formed. While the father substrate 302 includes the impressions 304 and the impressions 306, which are substantially similar to the functional light structures 204 and the one or more grooves 206 desired to be formed on the lacquer layer 203, the stamper 300 is formed to include negative impressions of the functional light structures 204 and the one or more grooves 206. For example, if a square cross-section groove is desired on the lacquer layer 203, then the father substrate 302 includes a corresponding square cross-section groove in the impressions 306 and the stamper 300 will include a corresponding square cross-section protrusion.

In this exemplary process, instead of directly manufacturing the stamper 300 with photolithography, it is explained to manufacture the father substrate 302 with photolithography and the stamper 300 is formed from the father substrate 302 by using the electroplating process. Since, multiple replicas of the stamper 300 have to be prepared for mass production and the photolithography is an expensive process to be implemented for multiple processes, therefore, the exemplary process has shown to form only the father substrate 302 by photolithography, after which, multiple replicas of the stamper 300 can be formed from the father substrate 302 by using the electroplating process. The process of forming the stamper 300 from the father substrate 302 is hereinafter referred to as duplication for easy understanding.

In an embodiment, the father substrate 302 can be duplicated by using an electroplating process. However, it should be appreciated that other methods are also possible. Moving on to FIG. 3b, in the electro-plating process the father substrate 302 is sputtered with a metal layer, typically a nickel-alloy or a silver-alloy, to form a conducting electrode and a seed layer 306 for plating process. In an embodiment, the stamper 300 can be a flexible stamper 300, in which case it can be formed by processes other than electroplating. In one exemplary embodiment, the flexible stamper 300 is formed by casting of a thermoplastic polymer or rubber. In another exemplary embodiment, the flexible stamper 300 is formed by, casting of epoxy (i.e. pre-mixing a monomer and a polymerization initiator shortly before use). In yet another exemplary embodiment, the flexible stamper 300 is formed by photo curing of a lacquer material. In yet another exemplary embodiment, the flexible stamper 300 is formed by dispensing a metal paste or solution, for example, Leitsilber, a silver dispersion in an organic liquid followed by thermal curing.

Subsequently moving on to FIG. 3c, a stamper 300 is grown on top of the seed layer 306. The stamper 300 is typically metallic, like nickel or silver. The stamper 300 is subsequently removed from the father substrate 302, and includes a base 308 having a mating surface 310. The mating surface 310 is the surface of the stamper 300 that contacts with the lacquer layer 203 deposited on the base substrate of the optoelectronic device. The mating surface 310 further includes negative impressions 312 of the functional light structures 204 on a first portion of the mating surface 310 and negative impressions 314 of the one or more grooves on a second portion of the mating surface 310, as can be seen in FIG. 3d. The negative impressions 312 and the negative impressions 314 can be explained in light of FIGs. 3a and 3d. The negative impressions 312 are a complementary to the impressions 304 and vice versa. For example, if a conical shape is desired in the functional light structures to be formed on the lacquer layer 203 of the optoelectronic device, then impressions 304 in the father substrate 302 includes the conical shape and the impressions 312 in the stamper 300 include a corresponding hollow cone.

The stamper 300 has the advantage of having highly optimized and efficient designs of the functional light structures. The electro-plating process used is very accurate up to dimensions on sub-micron size scale and also allows easy and inexpensive scale up to large area surfaces. This enable the functional light structures to be formed as periodic or quasi-periodic structures with a controlled and precise distance at sub-micron level. Additionally, the size, cross-section and placements of the one or more grooves can also be precisely optimized and controlled.

The stamper 300, the negative impression 312 and the negative impression 314 shown in the figures are mere illustrations and have been provided for the purpose of easy description of the invention. It should be understood that the figures have not been drawn to scale and have been drawn to provide an easy understanding of the concept behind the invention.

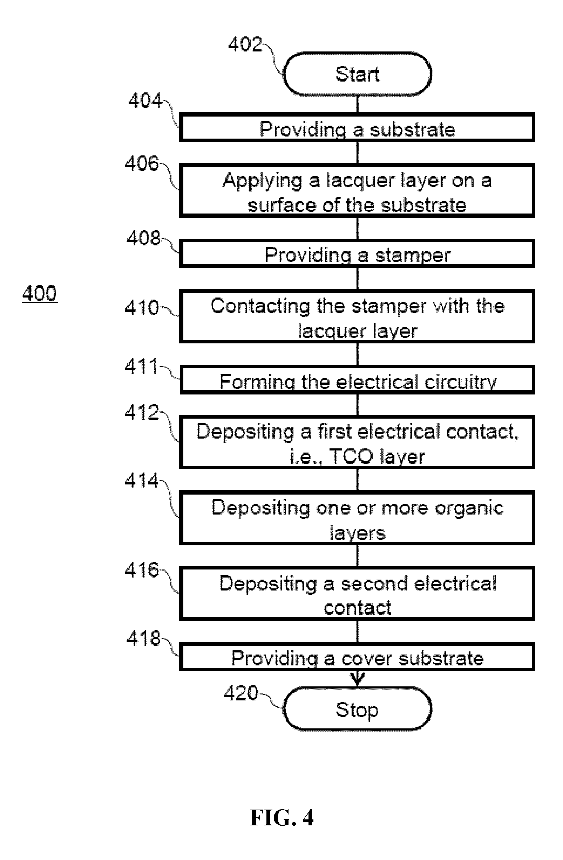

Moving on to FIG. 4, there is shown a flowchart depicting a method 400 of manufacturing an optoelectronic device, for example the OLED 100a, in accordance with an embodiment of the present invention. To describe the method 400, reference will be made to FIGs. 1, 2a, 2b, 2c, 2d, 3a, 3b, 3c and 3d, although it is understood that the method 400 can be implemented to manufacture any other suitable device. Moreover, the invention is not limited to the order of in which the steps are listed in the method 400. In addition, the method 400 can contain a greater or fewer numbers of steps than those shown in FIG. 4.

Further, for the purpose of this description, the method 400 has been explained in reference to an OLED in which the functional light structures are used for light extraction, however, it will be readily apparent to those ordinarily skilled in the art that the present invention can be implemented in an OPV device as well for light management purposes, like, light trapping.

The method 400 is initiated at step 402. At step 404, a substrate, for example the base substrate 104, having a substantially flat surface is provided.

Thereafter, at step 406 a curable lacquer material is applied on the base substrate 104 to form a lacquer layer, for example, the lacquer layer 203. Examples of the curable lacquer material can include, but are not limited to, an ultra-violet curable material, a photo-polymer lacquer, an acrylate, silica or silica-titania based sol-gel materials, electrically curable materials and a mixture of reactive components that facilitate curing, for example, by an exothermic reaction between themselves. However, it should be understood that the lacquer layer 203 can be formed of any material having similar characteristics without deviating from the scope of the invention. For example, the lacquer layer 203 can also be deposited by using a brush or roller, dispensing, slot dye coating, spin-coating, spray coating, or printing.

Thereafter, at step 408 a stamper, for example the stamper 300, is provided. The stamper 300 includes negative impression 312 of the functional light structures 204 and the negative impressions 314 of the one or more grooves 206 on its mating surface 310. The stamper 300 is contacted with the curable lacquer material to simultaneously replicate the functional light structures 204 and the one or more grooves 206 onto the lacquer layer 203 at step 410. Referring to FIG. 2a, formation of the one or more grooves 206 and the functional light structures 204 on the base substrate 202 can be seen.

In an embodiment, the step 410 can be performed is multiple sub-steps. Firstly, the lacquer layer 203 is heated to a temperature just above the glass transition temperature of a material of the lacquer layer 203. This softens the lacquer layer 203. Secondly, the stamper 300 is pressurized against the softened lacquer layer 203. This pressurizing enables replication of the functional light structures 204 and the one or more grooves 206 on the lacquer layer 203. Thereafter, the lacquer layer 203 with the functional light structures 204 and the one or more grooves 206 is cooled to return from the softened state to its normal hardness at room temperature.

In another embodiment, the step 410 can be implemented by using a stamping followed by application of a photo- curing process to affix the functional light structures 204 and the one or more grooves 206 on a surface of the lacquer layer 203.

In another embodiment, the step 410 can be implemented by using a stamping followed by application of heat to affix the functional light structures 204 and the one or more grooves 206 on a surface of the lacquer layer 203.

In yet another embodiment, there may be no lacquer layer 203 and the functional light structures 206 and the one or more grooves are formed by stamping the substrate 202 directly.

The method 400 allows simultaneous formation of periodic or quasi-periodic functional light structures 204 and the one or more grooves 206 on the lacquer layer 203 thereby saving production time during manufacture of the optoelectronic device.

Thereafter, at step 411, the electrical circuitry, for example, the electrical circuitry 208 is formed on the one or more grooves 206. In an embodiment the electrical circuitry 208 is formed by printing an electrically conducting material in the one or more grooves 206. In another embodiment, the electrical circuitry 208 is formed by dispensing an electrically conducting material in the one or more grooves 206. In an exemplary embodiment, the electrical circuitry 208 is formed by applying the electrically conducting material as a paste on the one or more grooves 206. In another exemplary embodiment, the electrical circuitry 208 is applied by screen printing the electrically conducting material on the one or more grooves 206 followed by thermal curing. In another exemplary embodiment, the electrical circuitry 208 is applied by ink-jet printing the electrically conducting material on the one or more grooves 206 followed by thermal curing. Other exemplary processes for forming the electrical circuitry 208 include, but are not limited to, evaporation, melt dispensing and powder sintering of the electrically conducting material to get deposited in the one or more grooves 206.

One real-life exemplary formation of the electrical circuitry 208 may include screen printing of a paste of Silver, followed by thermal annealing to sinter the Silver.

Another real-life exemplary formation of the electrical circuitry 208 may include ink jet printing of molten metals, like, Tin, Cadmium and other metals having lower melting points.

Subsequently, at step 412, a TCO layer, for example the first electrical contact 110 is deposited with conventional known methods on the internal light extraction layer 106. The first electrical contact 110 deposited. The first electrical contact 110 can be deposited by using various methods, such as dip coating, spin coating, doctored blade, spray coating, screen printing, sputtering, glass mastering, photoresist mastering, electroforming, and evaporation. In an embodiment, the first electrical contact 110 acts as an anode.

Thereafter, at step 414, one or more organic layers, for example the one or more organic layers 112 and 114 are deposited on the first electrical contact 110. The one or more organic layers 112 and 114 can be deposited by using various methods, such as dip coating, spin coating, doctored blade, spray coating, screen printing, sputtering, glass mastering, photoresist mastering, all kinds of CVD, electroforming, and evaporation.

Thereafter, at steps 416 and 418 a second electrical contact and a cover substrate are applied using conventional methods. Following which the method 400 is terminated at step 420.

Various embodiments, as described above, provide a method of simultaneously forming functional light structures and one or more grooves in an optoelectronic device. The method provided by the invention has several advantages. Since the method allows use of a stamper, best possible techniques to form optimized and efficient functional light structures can be used. Also, since the one or more grooves for holding the electrical circuitry are transferred simultaneously, there is a reduction in the total number of steps of manufacturing the optoelectronic device, which further reduces the time and cost of manufacturing the optoelectronic device.

Furthermore, the electrical circuitry deposited in accordance with the present invention, i.e., within the grooves, does not protrude out of a surface of the lacquer layer and a flat surface is available for the first electrical contact to be deposited. This in turn prevents any in-homogeneity in thickness of the first electrical contact and also prevents any subsequent electronic problems or device degradation, for example, due to shorts in the optoelectronic device.

Additionally, since the electrical circuitry is formed in the one or more grooves, the shape and cross-section of the electrical circuitry can be controlled by controlling the cross-section of the one or more grooves. Prior to the invention, the electrical circuitry was deposited on the lacquer layer by screen printing and due to an absence of any guiding template, for example, the one or more grooves of the present invention, the shape and cross-section of the electrical circuitry could not be controlled by the deposition processes. This enables forming the electrical circuitry with a high aspect ratio, i.e., the ratio of the width to the height of the cross-section of the one or more grooves (or the electrical circuitry), and can give them a functionalities like light management, stress release, or other properties. For example, to obtain the electrical circuitry of a particular cross-section, for example, block-shape, V-shape or parabolic shapes the one or more grooves of corresponding shape is replicated on the lacquer layer.

The present invention can also enable superior light management when the one or more grooves of a V-shape cross-section are used. The V-shape electrical circuitry formed over the one or more grooves prevents a part of the light from wave guiding into the glass substrate, thus, increasing light extraction in an OLED.

Additionally, with the use of one or more grooves a wider range of materials can be used for forming the electrical circuitry. For example, lower viscosity electrically conducting materials also can be used by applying them with, say, ink-jet printing on the one or more grooves. This reduces the chances of spread-out of such materials outside of the grooves. Further, higher viscosity materials can also be used as before, for example by using screen printing.

Generally, in prior art, the electrical circuitry had the ability to pierce through the first electrical contact, for example, the TCO layer, and lead to shorting of the optoelectronic device. However, in the present invention, since the electrical circuitry is not protruding out, the chances of shorting are minimized. This advantage is more pronounced when a lower viscosity electrically conducting material is used for the electrical circuitry, as then a surface available for deposition of the TCO layer is smooth and the effect of protruding electrical circuitry is further minimized.

While the invention has been disclosed in connection with the preferred embodiments shown and described in detail, various modifications and improvements thereon will become readily apparent to those skilled in the art. Accordingly, the spirit and scope of the present invention is not to be limited by the foregoing examples, but is to be understood in the broadest sense allowable by law.

All documents referenced herein are hereby incorporated by reference.

## Claims

1. A method of simultaneously forming functional light structures (204) and one or more grooves (206) on a base substrate for use in an optoelectronic device (100a, 100b), said one or more grooves (206) being configured to hold an electrical circuitry (208), said method comprising:
- applying a lacquer layer (106, 122) on said base substrate (104, 120);
- pressurizing a stamper (300) against said lacquer layer (106, 122);
- forming said electrical circuitry (208) in said one or more grooves (206); **characterised in that**:
said pressurizing said stamper (300) comprises mating a mating surface of said stamper (300) with said lacquer layer (106, 122), said mating surface having negative impressions (314) of said one or more grooves (206) on a first portion and negative impressions (312) of said functional light structures (204) on a second portion, wherein said functional light structures (204) enable one of light trapping and light extraction, and
wherein said pressurizing said stamper (300) further comprises simultaneous forming of at least a portion of said one or more grooves (206) and at least a portion of said functional light structures (204) on said lacquer layer (106, 122).

2. The method according to Claim 1, wherein said forming comprises filling said one or more grooves (206) with an electrically conducting material to form said electrical circuitry (208).

3. The method according to Claim 1 or 2, further comprising curing said lacquer layer (106, 122) by exposing said lacquer layer (106, 122) to at least one of heat, light, ultra-violet radiations, pressure, and electric current.

4. The method according to one of Claims 1 to 3, wherein a material for said lacquer layer (106, 122) is a mixture of one or more reactive components capable of facilitating curing of said lacquer layer (106, 122) by reacting.

5. The method according to one of Claims 1 to 4, wherein said replicating comprises:
- heating said lacquer layer (106, 122) to a temperature greater than a glass transition temperature of said lacquer layer (106, 122), thereby softening said lacquer layer (106, 122);
- pressurizing said stamper (300) against said lacquer layer (106, 122), thereby enabling replication of said one or more grooves (206) and said functional light structures (204) onto said lacquer layer (106, 122); and
- cooling said lacquer layer (106, 122).

6. The method according to one of Claims 1 to 5, wherein said one or more grooves (206) have a rectangular cross-section.

7. The method according to one of Claims 1 to 6, wherein said electrical circuitry (208) does not protrude from said lacquer layer (106, 122).

8. The method according to one of Claims 1 to 7, wherein said electrical circuitry (208) effectively reduces a voltage drop in said optoelectronic device (100a, 100b).

9. The method according to one of Claims 1 to 8, wherein said lacquer layer (106, 122) comprises scattering particles.

10. The method according to one of Claims 1 to 9, wherein said optoelectronic device (100a, 100b) is one of Organic Photovoltaic Device (OPV), Organic Light Emitting Device (OLED) and Thin-Film Photovoltaic Device (TF-PV).

11. A stamper (300) for simultaneously forming functional light structures (204) and one or more grooves (206) on a lacquer layer (106, 122) disposed on a base substrate (104, 120) of an optoelectronic device (100a, 100b), said one or more grooves (206) being configured to hold an electrical circuitry (208), said stamper (300) comprising a mating surface configured to be pressurized against said lacquer layer (106, 122),
**characterised in that**
said mating surface comprises:
a first portion having negative impressions (314) of said one or more grooves (206); and
a second portion having negative impressions (312) of said functional light structures (204), wherein said functional light structures (204) enables one of light
trapping and light extraction;
wherein said stamper (300) enables simultaneous forming of at least a portion of said one or more grooves (206) and at least a portion of said functional light structures (204) on said lacquer layer (106, 122) when said mating surface is pressurized against said lacquer layer (106, 122).

12. A stamper (300) according to claim 11, wherein said stamper (300) is flexible.
